# EUROPÄISCHE PATENTSCHRIFT

(11) **EP 0 481 177 B1**
(45) Veröffentlichungstag und Bekanntmachung des Hinweises auf die Patenterteilung: **10.01.1996**
(21) Anmeldenummer: 91112676.1
(22) Anmeldetag: 27.07.1991
(51) Int. Cl.: H05K 1/18

(54) **Leiterplatte mit eingelöteter integrierter Schaltung**
Printed circuit board with soldered integrated circuit
Plaquette de circuit imprimé avec circuit integré soudé

(30) Priorität: 15.10.1990 DE 4032685
(43) Veröffentlichungstag der Anmeldung: 22.04.1992
(73) Patentinhaber: GRUNDIG E.M.V. Elektro-Mechanische Versuchsanstalt Max Grundig GmbH & Co. KG, D-90762 Fürth (DE)
(72) Erfinder: Keller, Klaus, c/o GRUNDIG E.M.V., Max Grundig, W-8510 Fürth (DE)

(56) Entgegenhaltungen:
- GB-A- 1 240 789
- US-A- 4 254 448

## Beschreibung

Die Erfindung betrifft ein Verfahren zum automatischen Bestücken und Verlöten einer einseitigen kaschierten Leiterplatte gemäß dem Oberbegrift des Anspruchs 1.

Die fortschreitende Automatisierung und Miniaturisierung von elektronischen Geräten fordert den Einsatz von immer kompakteren Bauteilen für die automatische Bauteilebestückung.

Elektrische Schaltkreise in PLCC-Gehäusen (plastic leaded chip carrier) sind kompakter als solche in DIL-Gehäusen (dual inline) und automatisch bestückbar. Allerdings sind die PLCC-Gehäuse aus geometrischen Gründen nur für die sogenannte Reflow-Lötung geeignet. Das wiederum zieht nach sich, daß eine gemeinsame Lötung von PLCC-Gehäusen zusammen mit diversen anderen Bauteilen mit bekannten wirtschaftlichen Lötverfahren, wie zum Beispiel der Schwallbad-Lötung, nicht erfolgen kann. Um überhaupt Leiterplatten mit PLCC-Bausteinen zusammen mit anderen Bauteilen einigermaßen wirtschaftlich herstellen zu können, müssen doppelt kaschierte Leiterplatten eingesetzt werden. Die PLCC-Bausteine befinden sich dabei auf der der Lötseite der herkömmlichen Bauteile entgegengesetzten Seite der Leiterplatte, damit durch die Schwallbad-Lötung die Lötstellen der Reflow-Lötung nicht beschädigt werden. Es sind also zwei Lötvorgänge notwendig, zum einen die Reflow-Lötung für den oder die PLCC-Bausteine und zum anderen zum Beispiel die Schwallbad- oder eine andere bekannte wirtschaftliche Lötung für die übrigen Bauteile auf der entgegengesetzten Leiterplattenseite. Damit wird der Herstellungsaufwand relativ hoch, da außer den beiden Lötvorgängen die doppelt kaschierte Leiterplatte benötigt wird, welche teurer als eine einfach kaschierte Platte ist.

Aufgabe der Erfindung ist es nun ein Verfahren zu finden, mit welchem einseitig kaschierte Leiterplatten mit herkömmlichen Bauteilen wie Radial-, Axial-, Hand - und SMD-Bauteilen zusammen mit PLCC-Bausteinen automatisch bestückt und gemeinsam nach einem bekannten wirtschaftlichen Lötverfahren zum Beispiel der Schwallbad-Lötung verlötet werden können.

Ein weiterer Teil der Aufgabe besteht darin, den oder die PLCC-Bausteine möglichst raumsparend auf der Leiterplatte unterzubringen.

Erfindungsgemäß wird diese Aufgabe durch die im kennzeichnenden Teil des Patentanspruchs 1 angegebenen Merkmale gelöst. Die Unteransprüche zeigen vorteilhafte Ausgestaltungen der Erfindung.

Es ist bekannt, integrierte Schaltungen in Kunststoffkörpern mit Anschlußkontakten in Ausschnitten einer Leiterplatte zu klemmen und mit dieser zu verlöten.

So ist beispielsweise aus der DE-OS 3527043 ein Verfahren zum Einlöten einer integrierten Schaltung in eine Leiterplatte bekannt. Bei diesem Verfahren wird das IC-Bauteil im Ausschnitt einer Leiterplatte mittels der federnden Anschlußkontakte eingeklemmt und mit den Leiterbahnen der Leiterplatte verlötet. Erfahrungsgemäß ist jedoch bei dieser Art der Befestigung von Bauteilen in Leiterplatten die Festigkeit der Lötverbindung gefährdet, wenn die fertige Leiterplatte irgendwelchen Durchbiegungen oder Verwindungen ausgesetzt wird. Da die unter Federspannung im Ausschnitt der Leiterplatte sitzenden Anschlußkontakte bei solchen Beanspruchungen der Leiterplatte eigenständige Bewegungen ausführen und damit von sich aus zusätzliche Kräfte auf die Lötverbindung ausüben, kann die Lötverbindung leicht beschädigt werden. Außerdem müssen vor dem Einsetzen der integrierten Schaltung in den Ausschnitt der Leiterplatte die Anschlußkontakte nach außen nachgebogen werden, damit sichergestellt ist, daß auch alle Kontakte mit Federkraft an der Ausschnittswandung anliegen.

Weiterhin ist aus der GB-PS 1240789 bekannt, eine integrierte Schaltung in eine Leiterplatte einzusetzen, mit den federnden Anschlußkontakten im Ausschnitt festzuklemmen und mit der Leiterplatte zu verlöten. Im Prinzip treten dabei dieselben Nachteile wie bei DE-OS 3527043 geschildert auf, wenn eine Leiterplatte ohne Durchkontaktierung der Ausschnittswandung verwendet wird. In der GB-PS 1240789 wird deshalb die bei der Leiterplattenherstellung aufwendige Durchkontaktierung eingesetzt.

Zum Stand der Technik bezüglich des raumsparenden Unterbringens von PLCC-Bausteinen auf Leiterplatten, ist das Dokument US-A-4254448 zu nennen. Dort wird die Herstellung einer elektronischen Schaltung auf einer Leiterplatte beschrieben. Die Bauteile sind u.a. PLCC-Bausteine, sowie diverse diskrete Bauteile. In die Leiterplatte sind Vertiefungen, wie Taschen und Rillen, eingeformt. In diese Vertiefungen werden nun die zu bestückenden Bauteile bis zur Hälfte ihrer Höhe eingelegt und durch Verformung von den mit der Leiterplatte gespritzten Erhebungen mittels Ultraschall in ihrer Position festgehalten. So gesichert werden die Bauteile nun mittels der Reflow-Lötung mit der Leiterplatte verlötet.

Die oben geschilderten Nachteile werden erfindungsgemäß vermieden. So wird nach der Erfindung eine preiswerte einseitig kaschierte Leiterplatte eingesetzt, die in den Ausschnittkanten nicht durchkontaktiert sein muß. Die PLCC-Bausteine werden entgegen ihrer ursprünglich vorgesehenen Bestückungsrichtung um 180° gewendet auf die Lötseite der Leiterplatte aufgesetzt, so daß nicht die Rundungen, sondern die aus dem Kunststoffgehäuse austretenden Teile der Anschlußkontakte auf den Leiterbahnen aufliegen. Der Ausschnitt in der Leiterplatte ist so groß gewählt, daß einerseits das Kunststoffgehäuse des PLCC-Bausteins leicht hindurchgeht, die Anschlußkontakte jedoch nicht. Der Baustein liegt damit lose in der Leiterplatte, die Anschlußkontakte sind nicht federnd gespannt. Es sind somit die wesentlichen Voraussetzungen geschaffen, eine in Bezug auf die Anschlußkontakte spannungsfreie Lötung zu erreichen. Durch Aufbringen von Kleberflecken an geeigneten Stellen wird der Baustein mit der Leiterplatte so verbunden, daß er zusammen mit der komplett bestückten Leiterplatte durch das wirtschaftliche Schwall-Lötbad gefahren werden kann.

Die Erfindung wird nachfolgend anhand der Zeichnungen näher erläutert.
- Fig. 1: zeigt eine Teilansicht einer einseitig kaschierten Leiterplatte, die mit SMD- und einigen diskreten Bauteilen bestückt ist und einen um 45° zur Außenkante der Leiterplatte liegenden Ausschnitt aufweist, in dem sich ein PLCC-Baustein befindet.
- Fig. 2: zeigt ebenfalls einen zusammen mit einigen anderen Bauteilen in eine einseitig kaschierte Leiterplatte eingelöteten PLCC-Baustein, jedoch parallel zu den Außenkanten der Leiterplatte liegend.
- Fig. 3: stellt einen Teilschnitt der in Fig. 2 dargestellten Leiterplatte dar.
- Fig. 4: zeigt eine Vergrößerung der im Kreis A der Fig. 3 gekennzeichneten Einzelheit.

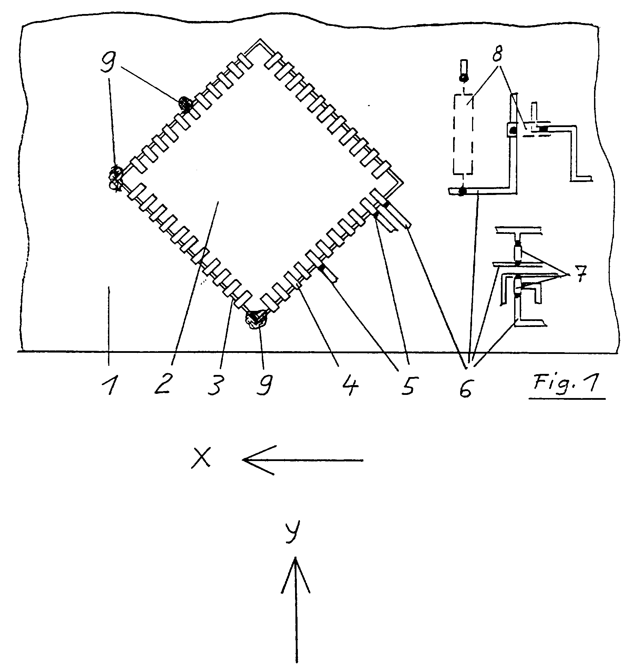

Die in Fig. 1 dargestellte Leiterplatte 1 hat einen um 45° zur Leiterplattenkante liegenden rechteckigen Ausschnitt 3 zur Aufnahme des PLCC-Bausteins 2. Diese Lage eignet sich besonders gut zum Löten nach dem Schwallband-Lötverfahren, wenn die Leiterplatte in Pfeilrichtung X oder Y durch das Schwallbad bewegt wird. Der Ausschnitt 3 ist größer als der Kunststoffkörper, aber kleiner als das durch die Kontaktfedern 4 gebildete Außenmaß des PLCC-Bausteins. Der Kunststoffkörper liegt also lose in dem Ausschnitt, während die Auflage der Kontaktfedern 4 auf den Leiterbahnen 6 ein Durchfallen des kompletten Bausteins verhindert. Zum Festhalten des PLCC-Bausteins in der Leiterplatte bis zur Lötung dienen einige Klebepunkte 9 an den Ecken oder/und an nicht benötigten Kontaktfedern des Bausteins. Die Fig. 1 zeigt andeutungsweise, daß auf der Leiterplatte 1 außer dem PLCC-Baustein noch SMD-Bauteile 7, sowie diverse diskrete Bauteile 8 vorhanden sein können. Die gesamte Leiterplatte kann automatisch bestückt werden. Die Leiterbahnen 6 sind nur teilweise gezeichnet. Die Leiterplatte 1 wird nun nach einem bekannten Lötverfahren, zum Beispiel der Schwallbadlötung, mit dem PLCC-Baustein 2 und den anderen Bauteilen 7, 8 verlötet.

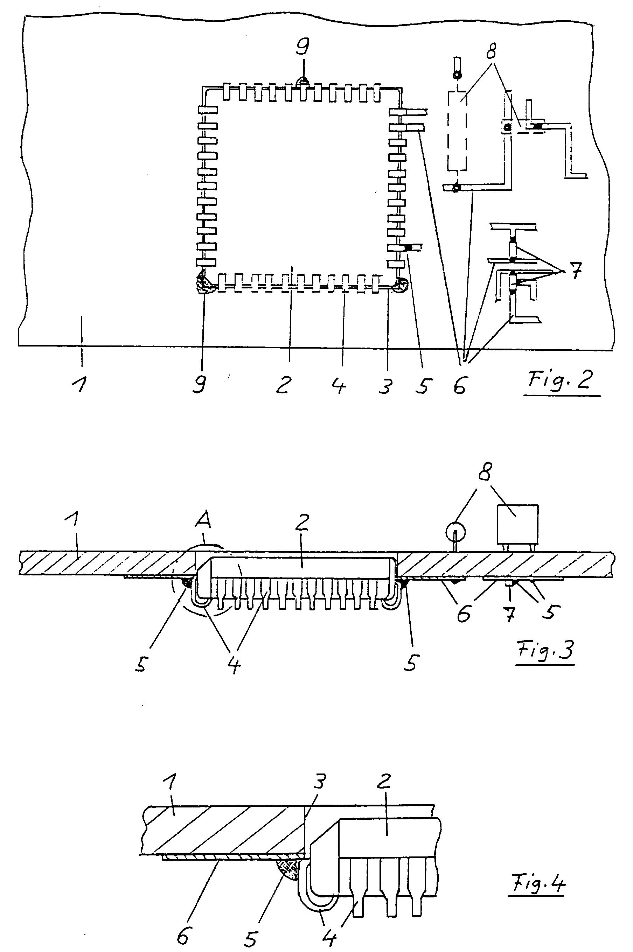

Die Fig. 2 stellt, abweichend von Fig. 1, eine Teilansicht einer Leiterplatte dar, in dem der Ausschnitt 3 und der PLCC-Baustein 2 aus Anordnungsgründen eine parallele Lage zu der Außenkante der Leiterplatte einnehmen.

In Fig. 3 ist zu sehen, daß der PLCC-Baustein 2 mit einem Großteil seines Volumens in dem Ausschnitt 3 der Leiterplatte 1 verschwindet. Damit kann ein erheblicher Raum gewonnen werden, was vor allem für miniaturisierte Geräte von großer Wichtigkeit ist. Die Lötstellen 5 befinden sich alle auf einer Seite der Leiterplatte, somit kann die Lötung in einem Arbeitsgang erfolgen.

In Fig. 4 ist eine Teilansicht des durch den Kreis A in Fig. 3 dargestellten Ausschnitts zu sehen. Durch den Spalt zwischen dem Ausschnitt 3 und dem PLCC-Baustein 2 ist erfindungsgemäß gewährleistet, daß der Kunststoffkörper des Bausteins vor dem Verlöten lose in der Leiterplatte liegt, was Voraussetzung für eine dauerhaft haltbare Lötverbindung auch bei Verwindung oder Verbiegung der Leiterplatte ist.

Die beschriebene Erfindung bezieht sich auf die Verwendung einer wirtschaftlich herstellbaren einseitig kaschierten Leiterplatte. Selbstverständlich können auch, wenn aus anderen Gründen erforderlich, beidseitig kaschierte Leiterplatten eingesetzt werden.

## Patentansprüche

1. Verfahren zum automatischen Bestücken und Verlöten einer einseitig kaschierten Leiterplatte, bei welchem die mit herkömmlichen Bauteilen, wie Radial-, Axial-, Hand- und SMD-Bauteilen bestückte Leiterplatte, zusammen mit mindestens einem PLCC-Baustein, welcher vor dem Löten mechanisch in der Leiterplatte gehalten wird, einem gemeinsamen Verlöten der Bauteile und des mindestens einen Bausteins mit der Leiterplatte (1) unterzogen wird,
**dadurch gekennzeichnet**, daß
- der PLCC-Baustein entgegen seiner ursprünglich vorgesehenen Bestückungsrichtung um 180° gewendet und in einen rechteckigen Ausschnitt (3) der Leiterplatte (1), der größer als die Außenkontur des Kunststoffgehäuses des PLCC-Bausteins (2), aber kleiner als das durch die Anschlußkontakte (4) bestimmte Außenmaß des PLCC-Bausteins (2) ist, von der Lötseite her in die Leiterplatte (1) eingesetzt wird,
- der PLCC-Baustein (2) mit seinen über die Kontur des Ausschnitts (3) hinausragenden Anschlußkontakten (4) auf den zum Ausschnitt (3) führenden Leiterbahnen (6) aufliegt,
- der in der Leiterplattenebene innerhalb des Ausschnitts (3) zunächst frei bewegliche PLCC-Baustein (2) durch eine oder mehrere Klebestellen (9) an den Außenkonturen des PLCC-Bausteins (2) mit der Leiterplatte (1) verklebt wird und
- daß das gemeinsame Verlöten der genannten Bauteile mit der Leiterplatte (1) mittels Schwallbad-Lötung erfolgt.

2. Verfahren nach Anspruch 1,
**dadurch gekennzeichnet**, daß der PLCC-Baustein (2) in einen um 45° zu einer Außenkanteder Leiterplatte (1) gedrehten rechteckigen Ausschnitt (3) eingelegt, verklebt und in der Richtung dieser Außenkante durch das Schwall-Lötbad bewegt wird.

3. Verfahren nach Anspruch 1,
**dadurch gekennzeichnet**, daß mehrere PLCC-Bausteine (2) zusammen mit diversen diskreten Bauteilen bestückt und mit der Leiterplatte verlötet werden.

4. Verfahren nach Anspruch 1,
**dadurch gekennzeichnet**, daß der PLCC-Baustein wahlweise an den Ecken und/oder an nicht benötigten Anschlußkontakten mit der Leiterplatte (1) verklebt wird.

## Claims

1. Method for the automatic assembly and soldering of a single-sided printed circuit board, in which the printed circuit board assembled with conventional components, such as radial, axial, manually inserted and SMD components is subjected, together with at least one PLCC package which is mechanically held in the printed circuit board before soldering, to a combined soldering of the components and of the at least one module to the printed circuit board (1), characterized in that
- the PLCC package is rotated through 180° with respect to its originally planned assembly direction and is inserted into a rectangular cutout (3) of the printed circuit board (1) which is larger than the outside contour of the plastics envelope of the PLCC package (2), but smaller than the overall size of the PLCC package (2) determined by the terminal contacts (4), the PLCC package (2) being inserted into the printed circuit board (1) from the solder side,
- the PLCC package (2) rests on the conductor tracks (6) leading to the cutout (3) by means of its terminal contacts (4) which project beyond the contour of the cutout (3),
- the PLCC package (2), which is initially freely movable in the plane of the printed circuit board within the cutout (3), is glued to the printed circuit board (1) by one or more glue points (9) on the outside contours of the PLCC package (2) and
- in that the combined soldering of the said components to the printed circuit board (1) takes place by means of wave soldering.

2. Method according to Claim 1, characterized in that the PLCC package (2) is laid in a rectangular cutout (3) rotated through 45° to an outside edge of the printed circuit board (1), glued and moved through the wave-soldering bath in the direction of said outside edge.

3. Method according to Claim 1, characterized in that a plurality of PLCC packages (2) are assembled together with various discrete components and soldered to the printed circuit board.

4. Method according to Claim 1, characterized in that the PLCC package is glued to the printed circuit board (1) optionally at the corners and/or at terminal contacts which are not needed.

## Revendications

1. Procédé pour équiper et fixer par brasage, de façon automatique, une plaquette à circuits imprimés dont une face est plaquée, selon lequel on soumet la plaquette à circuits imprimés équipée de composants usuels, tels que des composants amenés radialement, axialement et à la main et des composants SMD, conjointement avec au moins un module PLCC, qui est retenu mécaniquement dans la plaquette à circuits imprimés avant le brasage, à une opération commune de brasage des composants et du au moins un module sur la plaquette à circuits imprimés (1),
caractérisé en ce que
- on fait pivoter sur 180° le module PLCC dans le sens opposé de sa direction d'équipement prévue initialement et on l'insère à partir de la face de brasage, dans la plaquette à circuits imprimés (1), dans une découpe rectangulaire (3) de la plaquette à circuits imprimés (1) qui est d'une taille supérieure au contour extérieur du boîtier en matière plastique du module PLCC (2), mais est inférieure à la taille extérieure du module PLCC (2) déterminée par les contacts de raccordement (4),
- le module PLCC (2) s'applique, par ses contacts de raccordement (4) qui font saillie au-delà du contour de la découpe (3), sur les voies conductrices (6) s'étendant jusqu'à la découpe (3),
- on colle le module PLCC (2), tout d'abord librement mobile à l'intérieur de la découpe (3) dans le plan de la plaquette à circuits imprimés, à la plaquette à circuits imprimés (1) au moyen d'un ou de plusieurs points de colle (9) au niveau des contours extérieurs du module PLCC (2), et
- en ce que la fixation commune par brasage desdits composants à la plaquette à circuits imprimés (1) est réalisée au moyen d'un brasage dans un bain de brasage à la vague.

2. Procédé selon la revendication 1, caractérisé en ce que l'on insère le module PLCC (2) dans une découpe rectangulaire (3) pivotée de 45° par rapport à un bord extérieur de la plaquette à circuits imprimés (1), on le colle et on le déplace en direction de ce bord extérieur à l'intérieur du bain de brasure à la vague.

3. Procédé selon la revendication 1, caractérisé en ce qu'on équipe plusieurs modules PLCC (2) conjointement avec divers composants discrets et qu'on les fixe par brasage à la plaquette à circuits imprimés.

4. Procédé selon la revendication 1, caractérisé en ce que l'on colle le module PLCC, au choix au niveau des angles et/ou en des contacts de raccordement non nécessaires, à la plaquette à circuits imprimés (1).
